# EUROPÄISCHE PATENTSCHRIFT

(11) **EP 0 843 317 B1**
(45) Veröffentlichungstag und Bekanntmachung des Hinweises auf die Patenterteilung: **26.03.2003**
(21) Anmeldenummer: 97115648.4
(22) Anmeldetag: 09.09.1997
(51) Int. Cl.: G11C 29/00

(54) **Verfahren zum Testen eines in Zellenfelder unterteilten Speicherchips im laufenden Betrieb eines Rechners unter Einhaltung von Echtzeitbedingungen**
Method for testing of a field divided memory chip during run-time of a computer while maintaining real-time conditions
Méthode de test d'une puce de mémoire divisé en champs de cellules pendant le fonctionnement de l'ordinateur en maintenant des conditions de temps réel

(30) Priorität: 14.11.1996 DE 19647159
(43) Veröffentlichungstag der Anmeldung: 20.05.1998
(73) Patentinhaber: Infineon Technologies AG, 81669 München (DE)
(72) Erfinder: Eckardt, Horst, Dr., 71737 München (DE)
(74) Vertreter: Fischer, Volker, Dipl.-Ing.

(56) Entgegenhaltungen:
- DE-A- 3 530 257
- DE-A- 3 817 857
- M. FRANKLIN ET AL.: "Hypergraph coloring and reconfigured RAM testing" IEEE TRANSACTIONS ON COMPUTERS., Bd. 43, Nr. 6, Juni 1994, Seiten 725-736, XP000448647 NEW YORK US
- R. NAIR ET AL.: "Efficient algorithms for testing semiconductor random access memories" IEEE TRANSACTIONS ON COMPUTERS., Bd. 27, Nr. 6, Juni 1978, Seiten 572-576, XP002103902 NEW YORK US

## Beschreibung

Rechner werden heute oft in Anwendungsbereichen eingesetzt, die eine Reaktion innerhalb eines festgelegten Zeitintervalls erfordern. Man spricht hier von Echtzeitsystemen. Die Rechner können dabei als "Embedded System" in die Anwendung integriert werden oder beispielsweise als speicherprogrammierbare Steuerung bzw. Automatisierungsrechner getrennt davon realisiert sein. Solche Anwendungen erfordern einen unterbrechungsfreien Betrieb (hochverfügbare Systeme oder H-Systeme). In anderen Einsatzfällen darf die gesteuerte Anlage im Fehlerfall nicht in einen sicherheitskritischen Zustand versetzt werden, der zur Gefährdung von Meschenleben oder wertvollen Sachgütern führt (fehlersichere Systeme oder F-Systeme). Es können auch beide Anordnungen gleichzeitig auftreten (H+F-Systeme).

In allen drei genannten Betriebsmodi ist es erforderlich, daß der Rechner Möglichkeiten zum Selbsttest im laufenden Betrieb besitzt. Damit kann ein Auftreten der Fehler lokalisiert werden, und fehlerhafte Bauteile können eventuell schon erkannt werden, bevor sie einen fehlerhaften Zustand des Systems herbeiführen. Die am meisten gefährdeten Rechnerkomponenten sind die mit den meisten Trasistoren, also Speicher, Prozessoren und Peripherielogik.

Die hier vorgestellte Erfindung befaßt sich mit dem Testen von Speicherbausteinen. In Rechnern, in denen mehrere MBytes Speicher eingesetzt werden, enthält der Speicher die meisten Transistoren und stellt somit die wichtigste zu testende Komponente dar.

Man unterscheidet drei logische Fehlerklassen: Stuck-at-Fehler, Coupling-Fehler und Pattern-sensitive-Fehler [1]. Je nach Aufdeckungsgrad dieser Fehler wird den Speichertests eine bestimmte Wirksamkeit zugeordnet. Um hohe Wirksamkeit eines Tests zu erreichen, müssen alle Stuck-at-Fehler, die meisten Coupling-Fehler und viele Pattern-sensitive-Fehler erkannt werden.

Es ist bekannt, daß der Test mit der geringsten Komplexität und somit der kürzesten Ausführungszeit der Test von Nair, Thatte und Abraham [2], kurz Nair-Test genannt, ist.

Weiterhin bekannt sind Franklin-Tests [3], die bei höherer Komplexität bei hoher Bauteilintegration wichtige Pattern-sensitive-Fehler noch besser erfassen als der Nair-Test. Die Franklin-Tests können als logische Erweiterung des Nair-Tests angesehen werden, da sie beliebige 3-fach-Fehler entdecken, während der Nair-Test nur solche 3-fach-Fehler aufdeckt, bei denen alle beteiligten Speicherzellen disjunkt sind. Somit sind die Franklin-Tests, ebenso wie der Nair-Test, als hochwirksam einzustufen. Allen diesen Tests ist gemeinsam, daß sie keine Kenntnis über die physikalische Zellenanordnung auf dem Chip verlangen. Zur korrekten Durchführung genügen die üblichen Herstellerangaben.

Aus [4] sind Verfahren zum Testen eines Speicherchips im laufenden Betrieb bekannt und werden in [4] als schritthaltende Datensicherungsmaßnahmen bezeichnet.

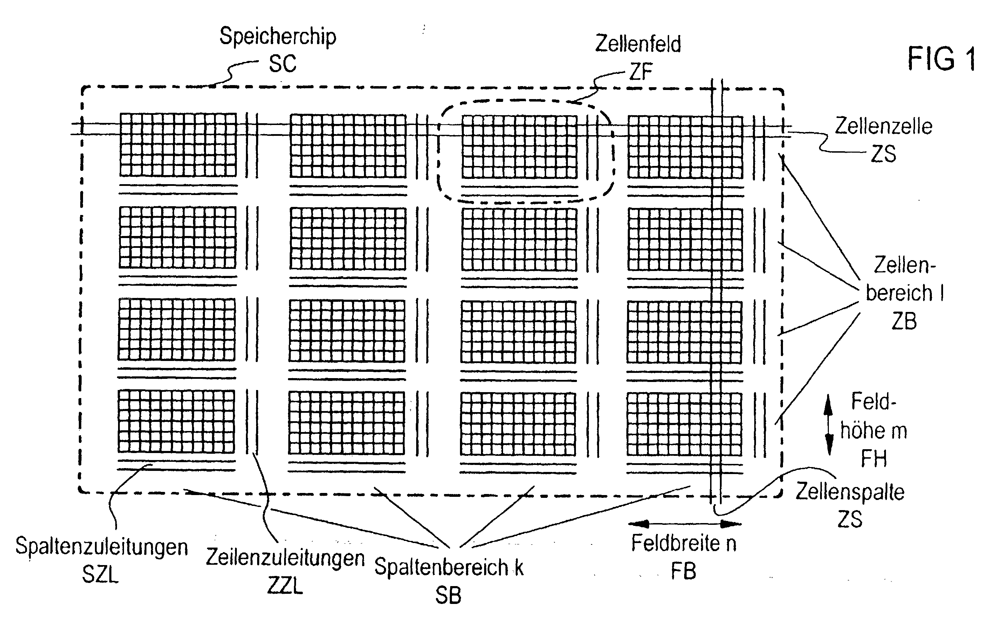

Aus [5] ist ein Verfahren zum Testen eines in Zellenfelder unterteilten Speicherchips bekannt (vergleiche dort Patentanspruch 9). Der Speicherchip in dem bekannten Verfahren ist gemäß einer Matrix unterteilt in Zeilenbereiche und Spaltenbereiche (vgl. Patentanspruch 1, 9; Figur 1).

Der Erfindung liegt das Problem zugrunde, daß Tests von Speicherchips im laufenden Betrieb unter Echtzeitbedingungen unterbrechbar sein müssen, damit die Reaktionsfähigkeit des Systems (typischerweise einige ms) nicht eingeschränkt wird (Wichtig: Tests hoher Wirksamkeit!). Die bekannten Speichertests hoher Wirksamkeit haben diese Eigenschaft nicht und können daher in Echtzeitrechnern nur als Einschalttests verwendet werden. Im laufenden Betrieb begnügt man sich mit Tests geringerer Wirksamkeit. Diese testen dann jeweils einen kleinen Speicherbereich in einem vorgegebenen Zeitslot. Währenddessen sind keine Unterbrechungen zugelassen, d. h. der Interrupt-Mechanismus des Rechners ist abgeschaltet.

Das Problem wird durch das Verfahren gemäß den Merkmalen des Patentanspruchs 1 gelöst.

Die Erfindung ermöglicht Tests eines in Zellenfelder unterteilten Speicherchips im laufenden Betrieb eines Rechners unter Einhaltung von Echtzeitbedingungen. Dabei wird hohe Wirksamkeit bei Unterbrechbarkeit des Tests gewährleistet.

Der Speicherchip kann unterteilt werden in einzelne Zellenfelder, die gemäß einer Matrix angeordnet sind. Diese Matrix ist unterteilt in Zeilenbereiche und Spaltenbereiche, wobei diese jeweils mindestens ein Zellenfeld aufweisen. Eine Zellenzeile ist bestimmt durch eine einzelne Zeile eines Zeilenbereichs und eine Zellenspalte ist bestimmt durch eine einzelne Spalte eines Spaltenbereichs.

Das Verfahren zum Testen des Speicherchips gestaltet sich wie folgt:
Ein erster Zeilenbereich wird ausgewählt. Falls der Inhalt dieses ersten Zeilenbereichs von einem Anwendungsprogramm belegt ist, muß der Inhalt in einen anderen freien zweiten Zeilenbereich umkopiert werden und die Adressierung des Anwendungsprogramms muß entsprechend über den zweiten Zeilenbereich modifiziert werden. Jeweils für alle Zellenfelder des ersten Zeilenbereichs wird ein Franklin-Test ausgeführt. Aus dem Zeilenbereich werden zwei Zellenfelder ausgewählt. Ein Nair-Test wird auf einer beliebigen Zellenzeile der beiden ausgewählten Zellenfelder durchgeführt. Um alle möglichen Zweierkombinationen von Zellenfeldern zu testen, wird der Nair-Test des letzten Schrittes mit je einem anderen Paar von Zellenfeldern wiederholt. Ein Nair-Test wird auf einer beliebigen Zellenspalte, beschränkt auf den ausgewählten ersten Zeilenbereich, durchgeführt. Die einzelnen Schritte des beschriebenen Verfahrens werden für alle Zeilenbereiche der Speicherchips ausgeführt.

Der zweite Teil des Verfahrens verläuft wie folgt: Ein Paar von Zeilenbereichen wird ausgewählt. Falls einer der Zeilenbereiche oder beide Zeilenbereiche von einem Anwendungsprogramm belegt sind, wird der Inhalt des einen Zeilenbereichs oder beider Zeilenbereiche in einen oder zwei freie Zeilenbereiche umkopiert und die Adressierung des Anwendungsprogramms entsprechend für jeden umkopierten Zeilenbereich modifiziert. Je eine beliebige Zellenspalte wird aus beiden ausgewählten Zeilenbereichen gewählt. Ein Nair-Test wird auf beiden ausgewählten Zellenspalten durchgeführt. Die einzelnen Schritte dieses zweiten Teils werden mit je einem anderen Paar von Zeilenbereichen durchgeführt, bis alle möglichen Zweierkombinationen von Zeilenbereichen durchlaufen sind.

Der Franklin-Test im ersten Teil des Verfahrens testet auf dynamische, Pattern-sensitive-Fehler, die aufgrund von Kopplungen benachbarter Zellen auftreten. Diese Fehler werden durch Franklin-Tests erkannt, ohne daß die physikalische Zuordnung der Zellen der logischen Adressen bekannt sein muß. Die Nair-Tests im ersten Teil des Verfahrens und im zweiten Teil des Verfahrens testen auf statische Fehler (Kurzschlüsse) und Kopplungen zwischen Leitungen.

Es ist vorteilhaft, während der Durchführung der Nair-Tests keine Interrupts zuzulassen. Werden die Nair-Tests exklusiv durchgeführt, können Seiteneffekte durch Hauptspeicherzugriffe ausgeschlossen werden.

Ferner ist es vorteilhaft, mehrere Speicherchips eines Gesamtspeichers durch Paralleltests gleichzeitig zu testen. Dazu werden in alle Speicherchips dieselben Daten geschrieben und aus allen Speicherchips dieselben Daten gelesen.

Weiterhin ist es vorteilhaft, in Rechnersystemen, die über EDC-Mechanismen verfügen, durch Abfrage des EDC-Controllers festzustellen, ob ein Speicherfehler korrigiert worden ist, und ggf. die Fehlerart zu klassifizieren. Unter Voraussetzung der Reproduzierbarkeit des Fehlers, kann unterschieden werden in Stuck-at-Fehler, Kopplungsfehler und Pattern-sensitive-Fehler. Klassifikation eines Stuck-at-Fehlers tritt auf, wenn die Zelle einen anderen Wert als den direkt in sie geschriebenen enthält. Die anderen beiden Fehler, Kopplungsfehler und Pattern-sensitive-Fehler, werden gemäß dem Verfahren in Patentanspruch 1 aufgedeckt.

Weiterbildungen des erfindungsgemäßen Verfahrens ergeben sich aus den abhängigen Ansprüchen.

Die Erfindung wird anhand eines Ausführungsbeispiels, das in den Figuren dargestellt ist, weiter erläutert.

Es zeigen
- Fig. 1: eine Skizze, in der die physikalische Organisation eines Speicherchips dargestellt ist.
- Fig. 2: ein Ablaufdiagramm, in dem die einzelnen Verfahrensschritte dargestellt sind.

Fig. 1 repräsentiert eine mögliche physikalische Organisation eines Speicherchips SC. Dabei sind Zellenfelder ZF matrixförmig in Zeilenbereiche ZB und Spaltenbereiche SB eingeordnet. Eine Zellenzeile ZZ ist bestimmt durch eine einzelne Zeile eines Zeilenbereichs ZB und eine Zellenspalte ZS ist bestimmt durch eine einzelne Spalte eines Spaltenbereichs SB. Ein einzelnes Zellenfeld ZF hat die Feldbreite FB n und die Feldhöhe FH m. Weiterhin gibt es Zeilenzuleitungen ZZL und Spaltenzuleitungen SZL.

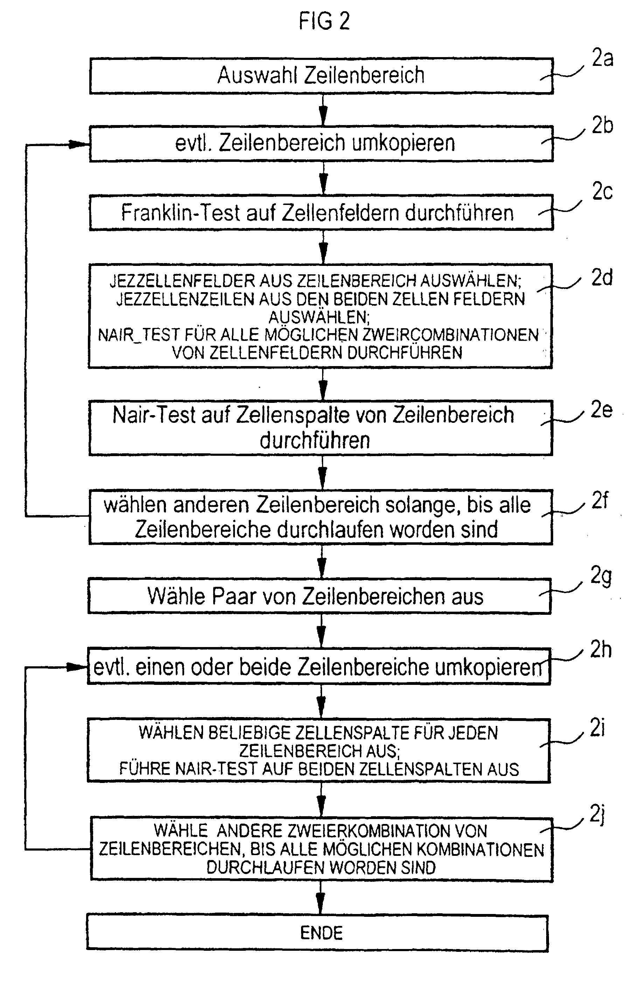

In Fig. 2 sind die einzelnen Verfahrensschritte des erfindungsgemäßen Verfahrens dargestellt. Für einen hochwirksamen Speichertest ist es wichtig, dynamische, Pattern-sensitive-Fehler, die aufgrund von Kopplungen benachbarter Zellen auftreten, und statische Fehler, die aufgrund von Kopplungen zwischen Leitungen auftreten, zu erkennen. Um hochwirksame Speichertests im laufenden Betrieb unter Echtzeitbedingungen durchführen zu können, wird ein zweistufiges Verfahren vorgestellt, das zuerst die dynamischen Pattern-sensitiven-Fehler, dann die durch Spaltenzuleitungen und/oder Zeilenzuleitungen in einem Zeilenbereich vorkommenden statischen Fehler untersucht, dies iterativ für alle Zeilenbereiche durchführt, und in einem zweiten Schritt für alle möglichen Zweierkombinationen von Zeilenbereichen die Zeilenzuleitungen des eigenen Zeilenbereichs gegen andere Zeilenzuleitungen testet. Dieses Verfahren, das auch in Fig. 2 beschrieben ist, wird im folgenden eingehend erläutert.

Zuerst wird ein erster Zeilenbereich ausgewählt (siehe Fig.2, Schritt 2a). Sollte der Inhalt dieses ersten Zeilenbereichs von einem Anwendungsprogramm belegt sein, wird dieser Inhalt in einen anderen freien Zeilenbereich umkopiert. Die Adressierung des Anwendungsprogramms ist entsprechend für den Zeilenbereich zu ändern (Schritt 2b). Jeweils für alle Zellenfelder des ersten Zeilenbereichs wird ein Franklin-Test durchgeführt (Schritt 2c). Danach werden zwei Zellenfelder aus dem Zeilenbereich ausgewählt. Eine beliebige Zellenzeile der betrachteten Zellenfelder wird jeweils ausgewählt. Kopplungen zwischen Spaltenzuleitungen werden getestet, indem ein Nair-Test für alle möglichen Zweierkombinationen von Zellenfeldern des Zeilenbereichs durchgeführt wird, wobei es genügt, den Nair-Test jeweils auf den ausgewählten Zellenzeilen durchzuführen (Schritt 2d). Kopplungen zwischen Zeilenzuleitungen werden getestet, indem ein Nair-Test auf einer beliebigen Zellenspalte des ausgewählten ersten Zeilenbereichs durchgeführt wird (Schritt 2e). Danach wird, solange noch nicht alle Zeilenbereich durchlaufen worden sind, ein anderer Zeilenbereich ausgewählt und zu Schritt 2b gesprungen (Schritt 2f). Sind alle Zeilenbereiche einzeln gemäß des oben beschriebenen Verfahrens getestet worden, so wird ein Paar von Zeilenbereichen ausgewählt (Schritt 2g). Benötigt ein Anwendungsprogramm Speicher eines Zeilenbereichs oder beider Zeilenbereiche, so muß jeder belegte Zeilenbereich in einen freien Zeilenbereich umkopiert werden und die Adressierung des Anwendungsprogramms entsprechend für jeden umkopierten Zeilenbereich modifiziert werden (Schritt 2h). Nun wird je eine beliebige Zellenspalte aus beiden ausgewählten Zeilenbereichen ausgewählt. Ein Nair-Test wird auf beiden ausgewählten Zellenspalten durchgeführt (Schritt 2i). Somit wird für Zeilenzuleitungen zwischen Zeilenbereichen eine Fehlerüberprüfung auf statische Fehler und Kopplungen zwischen Leitungen durchgeführt. Solange noch nicht alle möglichen Zweierkombinationen von Zeilenbereichen ausgewählt worden sind, wird eine neue mögliche Zweierkombination von Zeilenbereichen ausgewählt (Schritt 2j) und zu Schritt 2h gesprungen.

Der Franklin-Test ist von höherer Komplexität als der Nair-Test, dafür werden bei hoher Bauteilintegration wichtige Pattern-Sensitive-Fehler noch besser erfaßt. Franklin-Tests sind eine logische Erweiterung des Nair-Tests, da sie beliebige 3-fach-Fehler entdecken, während der Nair-Test nur solche 3-fach-Fehler aufdeckt, bei denen alle beteiligten Speicherzellen disjunkt sind. Da der Speichertest nach dem erfindungsgemäßen Verfahren im laufenden Betrieb des Rechners und unter Echtzeitbedingungen durchgeführt werden soll, wird der komplexere Franklin-Test nur auf einzelnen Zellenfeldern angewandt. Dort soll er dynamische, Pattern-sensitive-Feler aufdecken. Die statischen Fehler (Kurzschlüsse) und Kopplungen zwischen Leitungen werden in dem erfindungsgemäßen Verfahren durch Nair-Tests erkannt. Zur Aufdeckung der statischen Fehler können ebenfalls Franklin-Tests eingesetzt werden, wenn der Zeitaufwand, der in der höheren Komplexität der Franklin-Tests begründet ist, vertretbar ist.

Im Rahmen dieses Dokumentes wurden folgende Veröffentlichungen zitiert:
[1] DIN V VDE 0801/A1: 1994-10. Grundsätze für Rechner in Systemen mit Sicherheitsaufgaben.
[2] R.Nair, S.M.Thatte, J.A.Abraham, Efficient Algorithms for Testing Semiconductor Random-Access Memories. IEEE Trans. on Comp. C-27,6 (1978) 572-576.
[3] M.Franklin, K.K.Saluja, Hypergraph Coloring and Reconfigured RAM Testing. IEEE Trans. on Comp. 43,6 (1994) 725-736.
   M.Franklin, K.K.Saluja, An Algorithm to Test Reconfigured RAMs. 7th Intl. Conf.on VLSI Design, Calcutta, India, 5-8 Jan.1994, Comp.Soc.Press (1994) 359-364.
[4] D. Rhein, H. Freitag: Mikroelektronische Speicher, Springer-Verlag Wien, New York 1992.
[5] Deutsche Patentschrift 40 11 987 C2

## Patentansprüche

1. Verfahren zum Testen eines in Zellenfelder (ZF) unterteilten Speicherchips im laufenden Betrieb eines Rechners unter Einhaltung von Echtzeitbedingungen,
bei dem der Speicherchip (SC) gemäß einer Matrix unterteilt ist in Zeilenbereiche (ZB) und Spaltenbereiche (SB), wobei diese jeweils mindestens ein Zellenfeld (ZF) aufweisen und eine Zellenzeile (ZZ) eine einzelne Zeile eines Zeilenbereichs (ZB) bestimmt und eine Zellenspalte (ZS) eine einzelne Spalte eines Spaltenbereichs (SB) bestimmt,
mit folgenden Schritten:
a) ein erster Zeilenbereich (ZB) wird ausgewählt,
b) falls der Inhalt des ersten Zeilenbereichs von einem Anwendungsprogramm belegt ist, wird dieser Inhalt in einen anderen freien zweiten Zeilenbereich kopiert und die Adressierung des Anwendungsprogramms entsprechend für den zweiten Zeilenbereich modifiziert,
c) jeweils für alle Zellenfelder (ZF) des ersten Zeilenbereichs wird ein Franklintest ausgeführt,
d) zwei Zellenfelder werden aus dem Zeilenbereich ausgewählt,
e) ein Nair-Test wird auf einer beliebigen Zellenzeile (ZZ) der beiden ausgewählten Zellenfelder durchgeführt,
f) die Schritte d) bis e) werden mit einem anderen Paar von Zellenfeldern wiederholt, bis alle möglichen Zweierkombinationen von Zellenfeldern durchlaufen sind,
g) ein Nair Test wird auf einer beliebigen Zellenspalte (ZS), beschränkt auf den ausgewählten ersten Zeilenbereich, durchgeführt,
h) die Schritte b) bis g) werden für alle Zeilenbereiche des Speicherchips (SC) ausgeführt,
i) ein Paar von Zeilenbereichen wird ausgewählt,
j) falls einer der Zeilenbereiche oder beide Zeilenbereiche von einem Anwendungsprogramm belegt sind, wird der Inhalt des einen Zeilenbereichs oder beider Zeilenbereiche in einen oder zwei freie Zeilenbereiche umkopiert und die Adressierung des Anwendungsprogramms entsprechend für jeden umkopierten Zeilenbereich modifiziert,
k) je eine beliebige Zellenspalte wird aus beiden ausgewählten Zeilenbereichen gewählt,
l) ein Nair Test wird auf beiden ausgewählten Zellenspalten durchgeführt,
m) die Schritte j) bis l) werden mit einem anderen Paar von Zeilenbereichen durchgeführt, bis alle möglichen Zweierkombinationen von Zeilenbereichen durchlaufen sind.

2. Verfahrens nach Anspruch 1,
bei dem während der Durchführung des Nair-Tests keine Interrupts zugelassen werden.

3. Verfahren nach Anspruch 1 oder 2,
bei dem mehrere Speicherchips eines Gesamtspeichers durch Paralleltest gleichzeitig getestet werden, indem in alle Speicherchips dieselben Daten geschrieben und aus allen Speicherchips dieselben Daten gelesen werden.

4. Verwendung des Verfahrens nach Anspruch 1, 2 oder 3 zur Klassifikation von Fehlern in Rechnersystemen, die über EDC-Mechanismen verfügen,
bei der durch Abfrage des EDC-Controllers das Auftreten eines Fehlers bemerkt wird und dieser Fehler klassifiziert wird, indem unter Voraussetzung der Reproduzierbarkeit des Fehlers unterschieden werden kann in
- Stuck-at-Fehler, wenn die Zelle einen anderen Wert als den direkt in sie geschriebenen enthält,
- Kopplungsfehler, wenn die Schritte e) bis g) bzw. l) bis m) aus Anspruch 1 einen Fehler aufdecken,
- Pattern-sensitive-Fehler, wenn der Schritt c) aus Anspruch 1 einen Fehler aufdeckt.

## Revendications

1. Procédé de test d'une puce de mémoire subdivisée en champs (ZF) de cellules pendant le fonctionnement d'un ordinateur tout en maintenant des conditions de temps réel.
dans lequel la puce (SC) de mémoire est subdivisée suivant une matrice en zone (ZB) de lignes et en zone (SB) de colonnes, celle-ci ayant respectivement au moins un champ (ZF) de cellules et une ligne (ZZ) de cellules détermine une ligne individuelle d'une zone (ZB) de lignes et une colonne (ZF) de cellules détermine une colonne individuelle d'une zone (SB) de colonnes,
comprenant les stades suivants :
a) on sélectionne une première zone (ZB) de lignes,
b) dans le cas où le contenu de la première zone de lignes est occupé par un programme d'application, on copie ce contenu dans une autre deuxième zone de lignes libre et on modifie l'adressage du programme d'application en conséquence pour la deuxième zone de lignes,
c) on effectue respectivement pour tous les champs (ZF) de cellules de la première zone de lignes un test de Franklin,
d) on sélectionne deux champs de cellules dans la zone de lignes,
e) on effectue un test de Nair sur une ligne (ZZ) quelconque de cellules et deux champs de cellules sélectionnés,
f) on répète les stades d) à e) avec une autre paire de champs de cellules jusqu'à ce que toutes les combinaisons possibles deux à deux de champs de cellules soient épuisées,
g) on effectue un test de Nair sur une colonne (ZS) quelconque de cellules limité à la première zone de lignes sélectionnée,
h) on effectue les stades b) à g) pour toutes les zones de lignes de la puce (SC) de mémoire,
i) on sélectionne une paire de zones de lignes,
j) dans le cas où l'une des zones de lignes ou les deux zones de lignes sont occupées par un programme d'application, on recopie le contenu de l'une des zones de lignes ou des deux zones de lignes dans une ou deux zones libres de lignes et l'on modifie l'adressage du programme d'application, en conséquence, pour chaque zone de lignes recopiée,
k) on sélectionne respectivement une colonne quelconque de cellules dans les deux zones sélectionnées de lignes,
l) on effectue un test de Nair sur les deux colonnes sélectionnées de cellules,
m) on effectue les stades j) à l) sur une autre paire de zones de lignes jusqu'à ce que toutes les combinaisons possibles deux à deux de zone de lignes soient épuisées.

2. Procédé suivant la revendication 1,
dans lequel on n'autorise pas d'interruption pendant que l'on effectue le test de Nair.

3. Suivant la revendication 1 ou 2,
dans lequel on teste plusieurs puces de mémoire d'une mémoire globale simultanément par un test parallèle en écrivant les mêmes données dans toutes les puces de mémoire et en lisant les mêmes données dans toutes les puces de mémoire.

4. Utilisation et procédé suivant les revendications 1, 2 ou 3 pour la classification de défauts dans des systèmes informatiques qui disposent de mécanismes EDC,
dans lequel par interrogation du dispositif de commande EDC on remarque l'apparition d'un défaut et on classe ce défaut avec possibilité de distinguer en faisant l'hypothèse de la reproductibilité du défaut entre
- un défaut stuck-at lorsque la cellule contient une valeur autre que celle qui y a été écrite directement,
- un défaut de couplage lorsque les stades e) à g) ou l) à m) de la revendication 1 révèle un défaut,
- un défaut pattem-sensitive lorsque le stade c) de la revendication 1 révèle un défaut.

## Claims

1. Method for testing a memory chip, divided into cell arrays (ZF), during ongoing operation of a computer while maintaining real-time conditions, in which method the memory chip (SC) is divided into row areas (ZB) and column areas (SB) in accordance with a matrix, said areas each having at least one cell array (ZF) and a storage cell row (ZZ) determining an individual row of a row area (ZB) and a storage cell column (ZS) determining an individual column of a column area (SB), having the following steps:
a) a first row area (ZB) is selected,
b) if the content of the first row area is allocated to an application program, this content is copied into another free, second row area and the addressing of the application program is appropriately modified for the second row area,
c) a Franklin test is carried out in each case for all the cell arrays (ZF) of the first row area,
d) two cell arrays are selected from the row area,
e) a Nair test is carried out on any storage cell row (ZZ) of the two selected cell arrays,
f) the steps d) to e) are repeated with another pair of cell arrays until all the possible combinations of two cell arrays have been run through,
g) a Nair test is carried out on any storage cell column (ZS), restricted to the selected, first row area,
h) steps b) to g) are carried out for all the row areas of the memory chip (SC),
i) a pair of row areas is selected,
j) if one of the row areas or both row areas are allocated to an application program, the content of the one row area or of both row areas is copied over into one or two free row areas and the addressing of the application program is appropriately modified for each copied-over row area,
k) in each case any one storage cell column is selected from the two selected row areas,
l) a Nair test is carried out on the two selected storage cell columns,
m) steps j) to l) are carried out with a different pair of row areas until all the possible combinations of two row areas have been run through.

2. Method according to Claim 1, in which no interrupts are permitted during the execution of the Nair test.

3. Method according to Claim 1 or 2, in which a plurality of memory chips of an entire memory are tested simultaneously by means of parallel testing by writing the same data into all the memory chips and reading the same data out of all the memory chips.

4. Use of the method according to Claim 1, 2 or 3 for classifying faults in computer systems which have EDC mechanisms, in which the occurrence of a fault is perceived by interrogating the EDC controller, and this fault is classified, assuming the fault can be reproduced, by making a distinction between
- stuck-at faults if the storage cell has a different value than that directly written into it,
- connection faults if steps e) to g) or l) to m) from Claim 1 discover a fault,
- pattern-sensitive faults if step c) from Claim 1 discovers a fault.
